# EUROPEAN PATENT APPLICATION

(11) **EP 0 957 515 A1**
(43) Date of publication of application: **17.11.1999**
(21) Application number: 98830299.8
(22) Date of filing: 15.05.1998
(51) Int. Cl.: H01L 21/762

(54) **Method for manufacturing an SOI wafer**

(71) Applicant: STMicroelectronics S.r.l., 20041 Agrate Brianza (Milano) (IT)
(72) Inventor: Barlocchi, Gabriele, 20010 Cornaredo (IT); Villa, Flavio Francesco, 20159 Milano (IT)
(74) Representative: Cerbaro, Elena, Dr.

(57) **Abstract**

The method comprises the steps of: forming doped regions (11, 18) on a monocrystalline substrate (2); growing an epitaxial layer (16); forming trenches (25) in the epitaxial layer as far as the doped regions (18); anodising the doped regions (18) in an electron-galvanic cell to form porous silicon regions (18'); oxidising the porous silicon regions; removing the oxidised porous silicon regions (18'') thereby forming a buried air gap (27); thermally oxidising the wafer (15) thereby growing an oxide region (30) from the walls of the buried air gap (27) and the trenches (25), until the buried air gap and the trenches themselves are completely filled.

## Description

The present invention relates to a method for manufacturing an SOI wafer.

As known, according to a solution that is currently very widespread in the microelectronics industry, the substrate of integrated devices is obtained from wafers of monocrystalline silicon. In the last few years, as an alternative to wafers consisting of silicon alone, composite wafers, so-called "SOI" (Silicon-on-Insulator) wafers have been proposed, comprising two silicon layers, one of which is thinner than the other, separated by a silicon oxide layer (see for example the article "Silicon-on-Insulator Wafer Bonding - Wafer Thinning Technological Evaluations" by J. Hausman, G.A. Spierings, U.K.P. Bierman and J.A. Pals, Japanese Journal of Applied Physics, Vol. 28, No. 8, August 1989, pp. 1426-1443).

Considerable attention has recently been paid to SOI wafers, since integrated circuits that have a substrate formed from wafers of this type have considerable advantages compared with similar circuits formed on conventional substrates, consisting of monocrystalline silicon alone. These advantages can be summarised as follows:
a) faster switching speed;
b) greater immunity to noise;
c) smaller loss currents;
d) elimination of parasitic component switching phenomena ("latch-up");
e) reduction of parasitic capacities;
f) greater resistance to radiation effects; and
g) greater packing density of the components.

A typical process for manufacturing SOI wafers is described in the aforementioned article, and is based on gluing two monocrystalline silicon wafers ("wafer bonding" process). In particular, according to this process, one of the two wafers is oxidised, and after cleaning operations, it is bonded to the other wafer; after a thermal annealing step, the outer surface of the oxidised wafer is surface ground; polished until the required thickness is obtained (for example 1 µm), and finishing. An epitaxial layer, for integrating electronic components, is subsequently optionally grown on the thinner monocrystalline silicon layer.

The wafers obtained through the conventional wafer bonding method have excellent electrical features, but have undeniably high costs (approximately six times greater than the cost of the standard substrates).

Other methodologies, such as ZHR, SIMOX, etc., are described in the article "SOI Technologies: Their Past, Present and Future" by J. Haisha, Journal de Physique, Colloque C4, Supplément à no. 9, Tome 49, September 1988. These latter techniques have also not yet reached an acceptable industrial level, and have some limitations. In fact, they do not allow obtaining layers of monocrystalline silicon on extensive oxide areas, they have a high defect level owing to the displacements generated by stresses induced by the buried oxide, or they do not allow reaching high voltages as with SIMOX technology, where the oxide thickness obtained by oxygen implantation is approximately 100-200 nm.

The object of the invention is thus to provide a method for manufacturing SOI wafers, which exploits the intrinsic advantages of these technologies, but at competitive costs, and with the present standard, fully monocrystalline substrates.

According to the present invention, a method for manufacturing SOI wafers is provided as defined in claim 1.

A preferred embodiment of the present invention is now described, purely by way of non-limiting example, with reference to the attached drawings, wherein:
- figures 1-7 show cross-sections of an SOI wafer in successive manufacturing steps;
- figure 8 shows a top view of the wafer of figure 7;
- figures 9-13 show cross-sections of the present SOI wafer in further manufacturing steps; and
- figure 14 shows a top view of the wafer of figure 12.

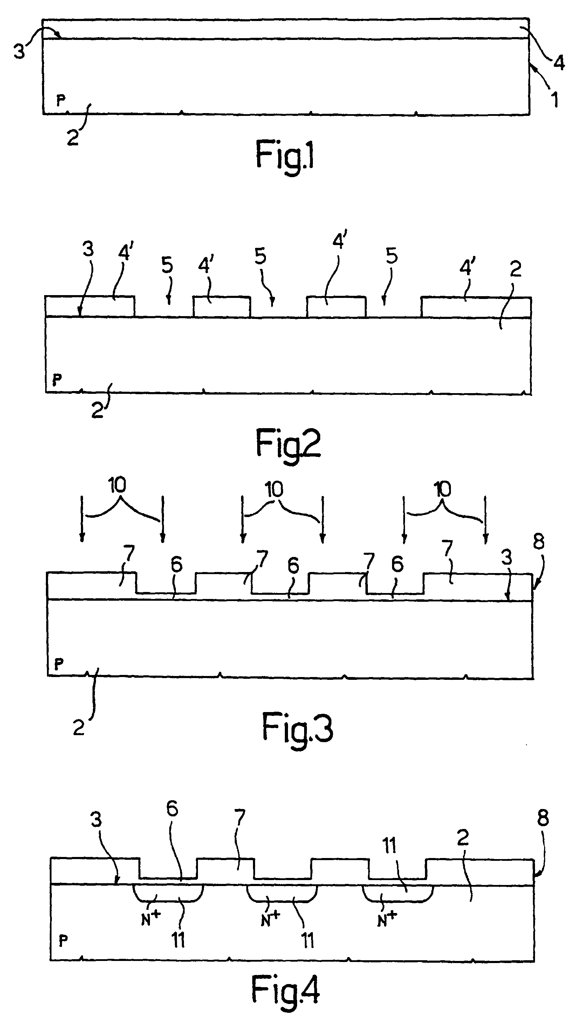

According to figure 1, a wafer 1, formed by a substrate 2 of monocrystalline silicon of P-type, is initially subjected to a standard thermal oxidation step, to grow, on one of its surfaces 3, a first silicon oxide layer 4, having a thickness for example of 2000-5000 Å.

Subsequently, through a resist deposition and a masking, areas are defined where first oxide layer 4 is removed, providing the intermediate structure of figure 2, wherein the remaining portions of first oxide layer 4 are indicated at 4' and delimit between them apertures 5, where the surface 3 of substrate 2 is uncovered. A light shielding oxidation is then carried out, which leads to the growth of a second thin oxide layer that, at the apertures 5, forms shielding portions 6 of a thickness of for example 200 Å, and elsewhere is joined to portions 4', forming protective portions 7; the protective portions 7 and the shielding portions 6 together form a shielding layer 8 (figure 3).

Subsequently, a high dose of arsenic or antimony is implanted (as shown schematically in figure 3 by arrows 10). In this step, the shielding portions 6 permit passage and implantation of the incident ions inside substrate 2, but attenuate impact with the surface 3 so as to reduce damage to the surface 3 itself; on the other hand the protective portions 7 block implantation of ions inside the underlying portions of substrate 2. At the end of implantation, drive-in is carried out at a high temperature, to activate and standardise the charges implanted in the substrate 2, such as to obtain regions 11 of N⁺-type (figure 4).

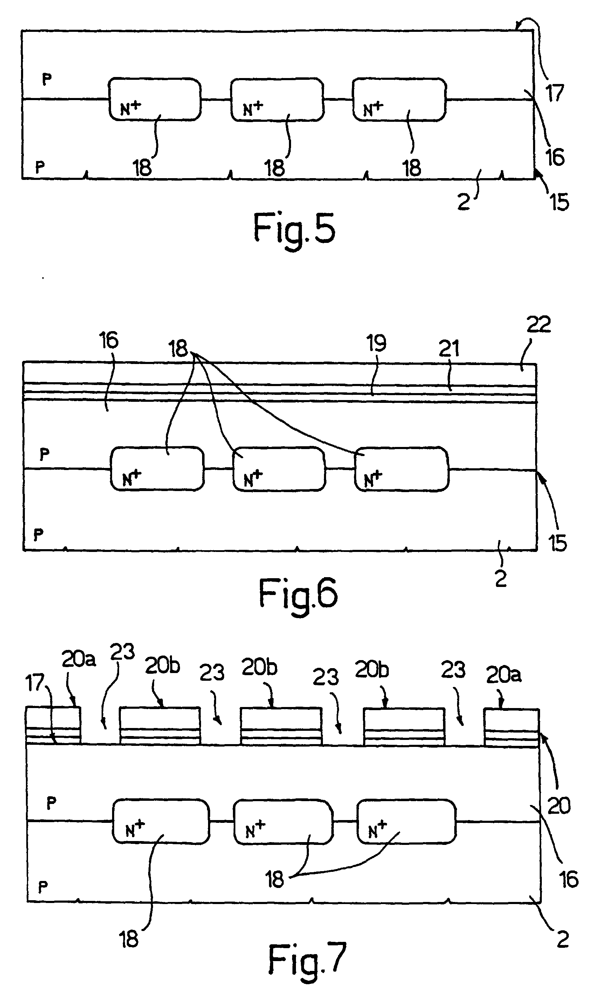

Shielding layer 8 is then completely removed, and an epitaxial layer is grown, with P doping, and preferably a same concentration as the substrate. At the end of the epitaxial growth, the wafer 15 of figure 5 is obtained, comprising substrate 2, an epitaxial region 16 (of P-doped monocrystalline silicon having a surface 17), and buried regions 18 of N⁺-type.

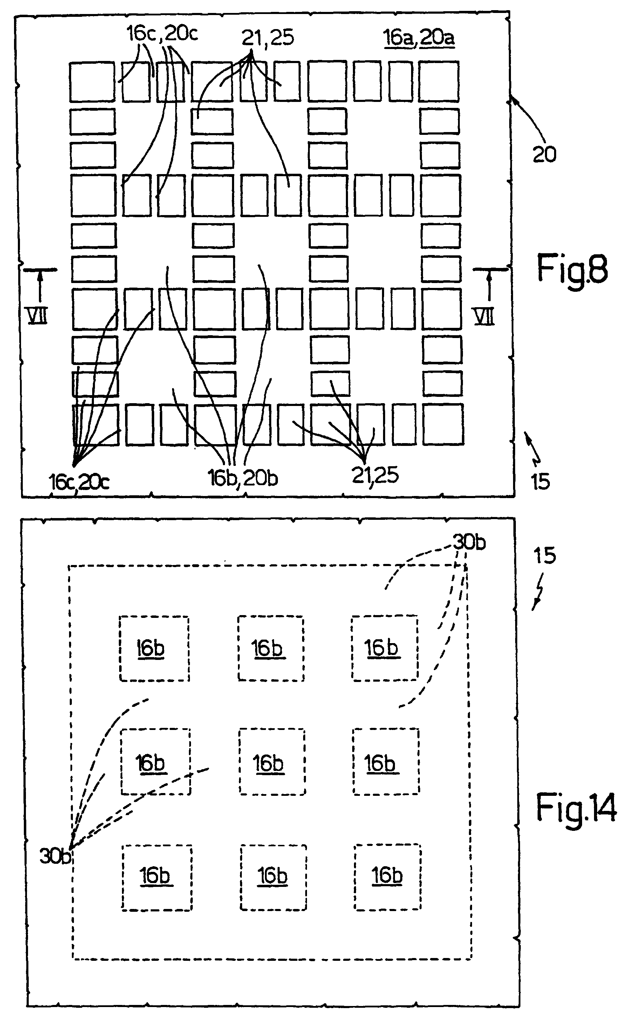

Subsequently, a masking layer is formed; for example, first a third silicon oxide layer 19 is grown (with a thickness of for example 200-600 Å), then in succession a silicon nitride layer 21 (with a thickness comprised between 900 and 1500 Å) and a TEOS (tetraethylorthosilicate) layer 22 (with a thickness comprised between 5000 and 7000 Å) are deposited. Thus, the intermediate structure of figure 6 is obtained. Through a further resist deposition and respective masking, TEOS 22, silicon nitride 21 and silicon oxide 19 layers are etched, forming a hard mask 20. Thus, the intermediate structure of figure 7 is obtained. In particular (see also the top view of figure 8), hard mask 20 comprises an outer portion 20a, covering the surface of wafer 15 on the exterior of the portion accommodating the buried regions 18, inner portions 20b aligned with the buried regions 18, and connection portions 20c connecting the inner portions 20 to one another and to the outer portion 20a, for reasons that will be explained hereinafter. As can be seen in figure 8, the connection portions 20c have a much smaller area than the inner portions 20b. Portions 20a, 20b and 20c form between each other apertures 23, where surface 17 of epitaxial layer 16 is uncovered.

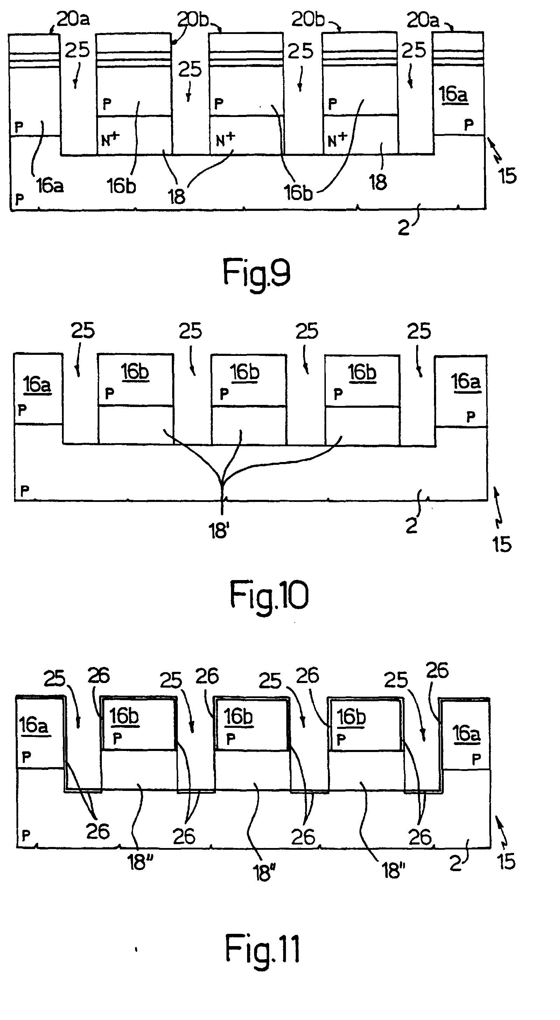

After defining hard mask 20, epitaxial layer 16 is etched at the apertures 23 by trench etching, forming trenches 25 that extend from surface 17 to buried regions 18, as shown in figure 9. In this step therefore, epitaxial layer 16 is divided into an outer epitaxial region 16a, the shape of which corresponds exactly to that of mask portion 20a; inner epitaxial regions 16b, the shape of which corresponds exactly to that of portions 20b; and epitaxial connection regions or pillars 16c (see figure 8), the shape of which corresponds exactly to that of portions 20c of mask 20.

Subsequently, hard mask 20 is removed; wafer 15 is then immersed in an electrolytic solution in a galvanic cell, and is subjected to an electrochemical etching step in hydrofluoric acid, such as described for example in the article "Epi-micromachining" P.J.French, P.T.J. Gennissen, P.M.Sarro, Microelectronics Journal 28 (1997), page 459. As discussed in this article, selective etching of the highly doped regions (here buried regions 18) is obtained, with formation of porosity. Consequently the material of the buried regions 18 is transformed from monocrystalline silicon into porous silicon, forming porous regions 18' (figure 10).

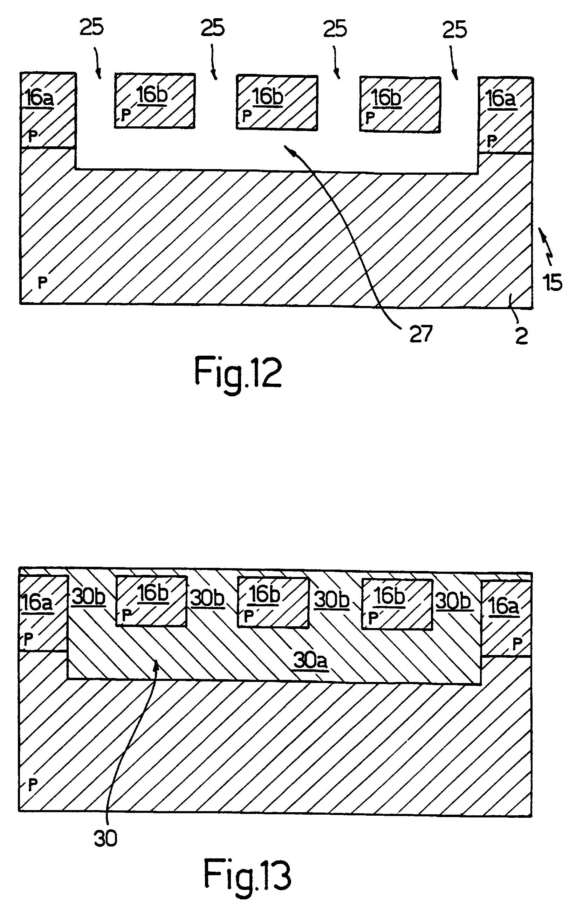

Wafer 15 is then subjected to oxidation in humid environment (for example H₂O₂); porous regions 18' react particularly, and are transformed into oxidised regions 18''; in this step a thin oxide layer is also formed, at the exposed silicon surfaces (as shown schematically by layers 26 in figure 11). Subsequently oxidised regions 18'' and thin oxide layers 26 are removed in hydrofluoric acid in an aqueous or anhydrous solution; thus the intermediate structure of figure 12 is obtained, wherein the inner epitaxial regions 16b of the epitaxial layer are separated from one another and from the outer epitaxial region 16a by the trenches 25 and from substrate 2 by an air gap 27, and are supported by the pillars 16c (figure 8).

The process continues with thermal oxidation, whereby the exposed silicon portions form silicon oxide regions. In particular, by appropriately dimensioning the various regions, due to the volume increase of the material during oxidation, the silicon oxide formed from substrate 2, outer epitaxial region 16a, inner epitaxial regions 16b, and pillars 16c expands until it completely fills the trenches 25 and the air gap 27, thus providing the final structure shown in figures 13 and 14, respectively in cross-section and in top view. In this step, pillars 16c are completely oxidised, since they have a much smaller area than inner epitaxial regions 20b. In practice, at the end of oxidation, inner epitaxial regions 16 are surrounded below and laterally by a single silicon oxide region 30, the lower portion 30a whereof defines an SOI area isolating substrate 2 from the individual inner epitaxial regions 16b (vertical SOI), and the vertical portions 30b whereof define SOI areas isolating the inner epitaxial regions 16b from each other and from the outer epitaxial region 16a (horizontal SOI).

Inside and/or outside the inner epitaxial regions 16b, standard electronic components may thus be formed, according to microelectronics conventional techniques, or sensors of different types (e.g. pressure, gas, temperature etc.), or microintegrated mechanical structures such as gyroscopes, micromotors and the like.

By virtue of the above described method, it is thus possible to manufacture SOI substrates using techniques similar to those used for microelectronics, and therefore with costs which are far lower than those currently used for manufacturing SOI substrates. In addition, the use of method steps which are well known and are already in use in manufacturing integrated circuits guarantees high levels of repeatability and reliability.

In addition, it is possible to adapt the dimensions, and thus the electrical features of the SOI wafer, to the specific applications, by selecting the depth of the trenches 25 according to the final electrical characteristics of the required SOI structure.

Finally, it is apparent that many modifications and variations may be made to the method described and illustrated here, all of which come within the scope of the invention, as defined in the attached claims. In particular, it is emphasised that the described method can be used irrespective of the conductivity type of the substrate and the epitaxial layer, and thus to combinations of substrate/epitaxial layer of the P/P, N/N, P/N and N/P type, exploiting the etching selectivity of silicon with respect to the doping level of the layers and regions, and varying the etching parameters, such as hydrofluoric acid concentration, supplied current, and shape and material of the etching mask, as discussed in the aforementioned article by P.J.French et al.

## Claims

1. A method for manufacturing an SOI wafer, characterised by the steps of:
- forming, inside a wafer (15) of monocrystalline semiconductor material having a surface (17), a buried air gap (27) and trenches (25) extending between said buried air gap and said surface; and
- forming an oxide region (30) inside said buried air gap and said trenches.

2. A method according to claim 1, characterised in that said step of forming a buried air gap (27) and trenches (25) comprises the steps of:
- forming said trenches (25) having a depth;
- anodising regions (18) in said wafer (15) arranged at said depth near said trenches, thereby obtaining porous sacrificial regions (18'); and
- removing said porous sacrificial regions (18').

3. A method according to claim 2, characterised in that said regions (18) of said wafer (15) comprise buried regions having a higher doping level than said wafer.

4. A method according to claim 3, characterised, before forming a buried air gap (27) and trenches (25), by the steps of:
- forming in a substrate (2) having a first conductivity type and a first doping level, regions (11) with a second conductivity type and a second doping level, higher than said first doping level;
- growing an epitaxial layer (16) on said substrate (2), said regions (11) with second conductivity type forming said buried regions (18).

5. A method according to any of claims 2-4, characterised, before said step of removing said porous sacrificial regions (18'), by the step of oxidising said porous sacrificial regions.

6. A method according to any of claims 1-5, characterised in that said step of forming a buried air gap (27) and trenches (25) comprises the steps of:
- masking said surface (17) of said wafer (15) through a mask (20);
- etching the trenches.

7. A method according to claim 6, characterised in that said mask (20) has an outer protective portion (20a), and inner protective portions (20b) arranged adjacent to each other, and connected to each other and to said outer protective portion (20a) by connection regions (20c) having a smaller area than said inner protective portions (20b).

8. A method according to any of claims 1-7, characterised in that said step of forming an oxide region (30) comprises the step of thermally oxidizing said wafer (15), thereby growing oxide regions on walls of said trenches (25) and of said air gap (27), said oxide region comprising portions (30b) filling said trenches, and portions (30a) filling said air gap.

9. An SOI wafer (15), characterised by:
- a substrate (2) of monocrystalline semiconductor material;
- a plurality of monocrystalline epitaxial regions (16a, 16b); and
- a single oxide region (30) comprising a lower portion (30a) interposed between said substrate (2) and said monocrystalline epitaxial regions (16b), and vertical portions (30b) extending between said lower portion and an upper surface (17) of said SOI wafer, and isolating said monocrystalline epitaxial regions (16a, 16b) from each other.
